# EUROPÄISCHE PATENTSCHRIFT

(11) **EP 3 498 940 B1**
(45) Veröffentlichungstag und Bekanntmachung des Hinweises auf die Patenterteilung: **12.08.2020**
(21) Anmeldenummer: 18207039.1
(22) Anmeldetag: 19.11.2018
(51) Int. Cl.: E05B 1/00, E05B 5/00, A47B 95/02, H05K 5/02, H02B 1/30, H02B 1/38, E05B 15/04, E05B 15/16

(54) **GRIFFELEMENT ZUR AUFNAHME IN DER FRONTSEITE EINER TÜR EINES SCHRANKS, INSBESONDERE SCHALTSCHRANKS**
GRIP ELEMENT FOR INSTALLATION IN THE FRONT END OF A CABINET DOOR, IN PARTICULAR A SWITCHING CABINET
ÉLÉMENT DE PRÉHENSION DESTINÉ À ÊTRE REÇU DANS LA FACE AVANT D'UNE PORTE D'UNE ARMOIRE, EN PARTICULIER D'UNE ARMOIRE ÉLECTRIQUE

(30) Priorität: 15.12.2017 DE 202017107662 U
(43) Veröffentlichungstag der Anmeldung: 19.06.2019
(73) Patentinhaber: ABB Schweiz AG, 5400 Baden (CH)
(72) Erfinder: Roth, Michael, 77880 Sasbach (DE); Kilgus, Kai, 76593 Gernsbach (DE); Goor, Gerrit Klaas, 3772NN Barneveld (NL); Witte, Adriaan Marinus, 2436 HT Nieuwegein (NL)

(56) Entgegenhaltungen:
- WO-A1-00/48872
- DE-U1- 9 402 761
- DE-U1-202007 006 691

## Beschreibung

Die Erfindung betrifft ein Griffelement zur Aufnahme in der Frontseite einer Tür eines Schranks, insbesondere eines Schaltschranks, gemäß dem Oberbegriff von Anspruch 1.

Aus der DE 94 02 761 U1 ist ein Griffelement zur Aufnahme in einer Tür eines Schranks bekannt, welches einen Gehäusegrundkörper besitzt, der in eine Öffnung in der Frontseite der Tür einsetzbar ist. Am Gehäusegrundkörper ist ein plattenförmiges Verschlusselement verschwenkbar aufgenommen, das aus einer ersten Schließposition, in der das plattenförmige Verschlusselement im Wesentlichen horizontal zur Frontseite der Tür ausgerichtet ist, in eine Öffnungsposition verschwenkt werden kann, in der eine Grifffläche des Verschlusselements aus der Türebene heraussteht und mit dem Daumen und dem Zeigefinger einer Hand ergriffen werden kann, um die Tür zu öffnen. Durch die parallele Ausrichtung des plattenförmigen Verschlusselements zur Frontseite der Tür wird bei dieser Art von Griffelementen vermieden, dass diese beschädigt oder zerstört werden, wenn in geringem Abstand an der Frontseite der Tür vorbei bewegte Objekte auf das Griffelement treffen. Ein weiterer Vorteil der vollständigen Einklappbarkeit des Verschlusselements besteht darin, dass auch die Gefahr von Verletzungen reduziert wird, da die lokale Druckbelastung auf ein menschliches Körperteil im Falle eines Auftreffens auf das Griffelement in Folge der gegenüber herausstehenden Griffelementen deutlich vergrößerten Kontaktfläche insgesamt verringert ist.

Um ein ungewolltes Herausschwenken des plattenförmigen Verschlusselements zu verhindern, wird dieses bei der zuvor genannten DE 94 02 761 U1 durch die Federarme einer Spiralfeder in die Schließposition gedrängt, welche auf einem Achszapfen des plattenförmigen Verschlusselements montiert ist, über den das Verschlusselement verschwenkbar am Gehäusegrundkörper aufgenommen ist. Da die Spiralfeder als zusätzliches Bauteil an dem Achszapfen separat montiert werden muss, ist die Anzahl an benötigten Teilen sowie der damit verbundene logistische Aufwand beim Zusammenbau der Griffelemente groß, was bei einer Massenfertigung wiederum zu erhöhten Produktionskosten führt. Zudem ist das Aufsetzen der Spiralfedern auf die Achsbolzen und das Einsetzen derselben im vorgespannten Zustand in den Gehäusegrundkörper schwierig, so dass diese Arbeiten in der Regel nur mit großem Aufwand automatisiert vorgenommen werden können.

Demgemäß ist es eine Aufgabe der vorliegenden Erfindung ein Griffelement zu schaffen, welches die Nachteile des Standes der Technik vermeidet.

Diese Aufgabe wird erfindungsgemäß durch ein Griffelement mit den Merkmalen von Anspruch 1 gelöst.

Eine weitere Aufgabe der Erfindung ist es, einen Schaltschrank zu schaffen, welcher sich mit verringertem Bauteil- und Vorrichtungsaufwand fertigen lässt.

Diese Aufgabe wird erfindungsgemäß durch einen Schaltschrank mit den Merkmalen von Anspruch 12 gelöst.

Weitere Merkmale der Erfindung sind in den Unteransprüchen beschrieben.

Gemäß der Erfindung umfasst ein Griffelement, welches zum Öffnen und Schließen einer Tür eines Schranks, insbesondere eines Schaltschranks, dient, einen halbschalenförmigen Gehäusegrundkörper, der in eine Öffnung in der Frontseite der Tür einsetzbar ist und in dieser vorzugsweise über Rastelemente gehalten wird.

Das erfindungsgemäße Griffelement umfasst weiterhin ein am Gehäusegrundkörper verschwenkbar aufgenommenes plattenförmiges Verschlusselement, welches durch federelastische Mittel beaufschlagt wird und aus einer Schließposition, in welcher das Verschlusselement den Innenraum des Gehäusegrundkörpers verschließt und plan zur Fläche der Frontseite der Tür ausgerichtet ist, in eine Öffnungsposition verschwenkbar ist, in welcher das Verschlusselement an einer Grifffläche ergriffen werden kann, um die Tür zu öffnen oder zu schließen.

Das erfindungsgemäße Griffelement zeichnet sich dadurch aus, dass die federelastischen Mittel ein integral mit dem Gehäusegrundkörper geformtes laschenförmiges Rückstellelement umfassen, welches auf die dem Innenraum zugewandte Innenseite des Verschlusselements wirkt und dieses in die Schließposition drängt.

Die Erfindung besitzt den Vorteil, dass der Gehäusegrundkörper und das laschenförmige Rückstellelement in kostengünstiger Weise einteilig, d.h. als ein und dasselbe Bauteil, im Spritzgussverfahren hergestellt werden können und für die Endmontage des erfindungsgemäßen Griffelements lediglich das Verschlusselement, welches auch als Klappe bezeichnet werden kann, über entsprechende zapfenartige Vorsprünge und zugehörige buchsenförmige Aufnahmen am Gehäusegrundkörper befestigt werden muss.

Ein besonderer Vorteil der erfindungsgemäßen Lösung ist darin zu sehen, dass das laschenförmige Rückstellelement nach dem Einsetzen desselben in den Gehäusegrundkörper bereits die gewünschte Vorspannung besitz, welche das plattenförmige Verschlusselement in der Schließposition gegen einen Anschlag am Gehäusegrundkörper drängt, so dass sich dieses immer in einer wohl definierten eingeschwenkten, d.h. plan zur Oberseite der Tür verlaufenden Position befindet, ohne in unerwünschter Weise aus dem Gehäusegrundkörper heraus zu stehen.

Nach einem weiteren der Erfindung zugrunde liegenden Gedanken erstreckt sich das laschenförmige Rückstellelement vom Boden des halbschalenförmigen Gehäusegrundkörpers aus durch den Innenraum hindurch bis zur Innenseite des Verschlusselements 8, und liegt mit seinem freien Ende an einem Anschlag an, der an der Innenseite des Verschlusselements 8 geformt ist und sich in entgegengesetzter Richtung in den Innenraum hinein erstreckt. Hierdurch ergibt sich der Vorteil, dass die gesamte Höhe des Innenraums dazu genutzt werden kann, das laschenförmige Rückstellelement in einer größtmöglichen Länge auszuführen, die dafür sorgt, dass das Element auch bei vergleichsweise unelastischen Werkstoffen, wie z.B. Metallblech oder Stahlblech, beim Verschwenken des Verschlusselements um die erforderliche Strecke in lateraler Richtung ausgelenkt werden kann, ohne plastisch irreversibel deformiert zu werden.

Weiterhin kann es vorgesehen sein, dass sich das laschenförmige Rückstellelement gegenüber dem Boden des halbschalenförmigen Gehäusegrundkörpers in einem Winkel von vorzugsweise 60° bis 80° geneigt durch den Innenraum hindurch erstreckt, wodurch sich die größtmögliche Länge des Elements nochmals vergrößern lässt. Ein weiterer Vorteil dieser geneigten Anordnung ist darin zu sehen, dass sich der Angriffspunkt des Anschlags, in welchem dieser das Rückstellelement kontaktiert, mit zunehmender Auslenkung des laschenförmigen Rückstellelements zunehmend zu dessen Ende hin bewegt, so dass die nach dem Hookschen Gesetz mit zunehmender Auslenkung des laschenförmigen Rückstellelements verbundene Zunahme der Rückstellkraft in vorteilhafter Weise zumindest zum Teil kompensiert wird. Anders ausgedrückt ergibt sich dadurch eine konstantere Gegenkraft, mit der das Verschlusselement in die Schließposition zurück gedrängt wird.

Nach einer Weiterbildung des der Erfindung zugrunde liegenden Gedankens, mit der sich die vom Verschlusselement ausgeübte Rückstellkraft weiter vergleichmäßigen lässt, ist das Verschlusselement um eine im Innenraum des Gehäusegrundkörpers liegende Schwenkachse verschwenkbar, die in einem Abstand A vom Anschlag angeordnet ist, so dass der Anschlag beim Verschwenken des Verschlusselements aus der Schließposition das freie Ende des laschenförmigen Rückstellelements in Richtung zur Schwenkachse hin auslenkt.

Bei einer bevorzugten Ausführungsform der Erfindung umfasst der Anschlag einen rippenartigen Vorsprung, der sich zumindest über einen Teil, vorzugsweise jedoch über die gesamte Breite des Verschlusselements hinweg erstreckt. Hierdurch ergibt sich der Vorteil, dass die Druckbelastung des Anschlags beim Öffnen des Verschlusselements gering gehalten werden kann, was die Gefahr von Ermüdungsbrüchen desselben verringert.

Nach einer vorteilhaften Weiterbildung der Erfindung kann es ferner vorgesehen sein, dass sich der rippenartige Vorsprung in einem rechten Winkel von der Innenseite des Verschlusselements in den Innenraum des halbschalenförmigen Gehäusegrundkörpers hinein erstreckt. Hierdurch wird sichergestellt, dass der rippenartige Vorsprung bei einer minimalen Länge des Vorsprungs das laschenförmige Rückstellelement stets sicher kontaktiert, ohne dass die Gefahr besteht, dass das freie Ende desselben bei einer schnellen Öffnungsbewegung des Verschlusselements über den Vorsprung hinweggleitet.

Gemäß einer weiteren vorteilhaften Ausführungsform der Erfindung, die einen besonders einfachen und zeitsparenden Zusammenbau des Griffelements ermöglicht, stützt sich das Verschlusselement über zapfenförmige Vorsprünge und hülsenförmige Aufnahmen verschwenkbar am Gehäusegrundkörper ab, welche in korrespondierende buchsenförmige Aufnahmen einrastbar sind. Hierbei können die zapfenartigen Vorsprünge am Verschlusselement und die buchsenförmigen Aufnahmen am Gehäusegrundkörper geformt sein. Alternativ besteht die Möglichkeit, die sich entlang der Schwenkachse erstreckenden zapfenförmigen Vorsprünge an der Wand des Gehäusegrundkörpers und die korrespondierenden buchsenförmigen Aufnahmen in Verdickungen an der Unterseite des Verschlusselements zu formen, wobei sowohl die zapfenartigen Vorsprünge, als auch die Aufnahmen vorzugsweise integral mit dem Gehäusegrundkörper, bzw. Verschlusselement, vorzugsweise als Spritzgussteil geformt sind. Das Einführen und Einrasten der zapfenartigen Vorsprünge in die buchsenförmigen Aufnahmen kann in besonders effizienter Weise dadurch erfolgen, dass der Gehäusegrundkörper in einer Ebene senkrecht zur Schwenkachse zusammen gedrückt wird, wodurch sich die zapfenartigen Vorsprünge, bzw. buchsenförmigen Aufnahmen voneinander weg bewegen und dadurch Platz schaffen, die freien Enden der zapfenartigen Vorsprünge über die Seitenwände des Gehäusegrundkörpers, bzw. die Verdickungen am Verschlusselement, in welchen die buchsenförmigen Aufnahmen geformt sind, hinweg in die Aufnahmen zu bewegen. Hierbei stellt es einen besonderen Vorteil der Erfindung dar, dass bei dem zuvor beschriebenen Einführen der zapfenartigen Vorsprünge in die Aufnahmen nicht zusätzlich auch eine Spiralfeder mit Vorspannung in entsprechende Aufnahmen eingeführt werden muss, wie dies beim zuvor genannten Stand der Technik erforderlich ist, da das laschenförmige Rückstellelement sozusagen automatisch in die richtige Position bewegt und zugleich vorgespannt wird. Ein weiterer Vorteil dieser zuvor beschriebenen Montageweise des Verschlusselements am Gehäusegrundkörper besteht darin, dass eine Aufweitung des Gehäusegrundkörpers nach dem Einsetzen desselben in die Öffnung einer Tür, welche eine der äußeren Form des Gehäusegrundkörpers angepasste Öffnungsform besitzt, wirksam verhindert wird, so dass ein Herausrutschen der zapfenartigen Vorsprünge aus den buchsenförmigen Aufnahmen auch bei sehr hohen Zugkräften am Verschlusselement ausgeschlossen ist.

Um eine zuverlässige, vorzugsweise bündige Anlage der Unterseite, bzw. der Oberseite des Verschlusselements an den entsprechenden Anlageflächen des Gehäusegrundkörpers in der Schließstellung zu gewährleisten, kann es weiterhin vorgesehen sein, dass in einem entfernt von der Grifffläche gelegenen Randbereich des Gehäusegrundkörpers eine Anschlagfläche geformt ist, auf welcher sich das Verschlusselement in der Schließposition abstützt.

Weiterhin kann, wie bereits zuvor erwähnt, an der Außenseite des halbschalenförmigen Gehäusegrundkörpers wenigstens ein elastisch deformierbares Rastelement geformt sein, welches z.B. eine im Querschnitt hakenartige Form aufweist und bevorzugt ebenfalls integral mit dem Gehäusegrundkörper geformt ist, und den Gehäusegrundkörper nach dem Einsetzen in eine in einer Tür eines Schranks geformte Öffnung in dieser gegen ein Herausrutschen fixiert.

Obgleich der Gehäusegrundkörper auch aus einem elastischen Metall, wie z.B. Stahlblech, geformt sein kann, besteht der Gehäusegrundkörper bei der bevorzugten Ausführungsform der Erfindung aus einem reversibel deformierbaren Kunststoffmaterial, insbesondere aus Polyamid oder Polypropylen oder PVC.

Um ferner die Gefahr eines Abrutschens vom Verschlusselement beim Öffnen der Tür so weit wie möglich zu verringern, kann die Grifffläche zur Erhöhung der Reibkraft beim Ergreifen des Verschlusselements mehrere Griffleisten umfassen, welche vorzugsweise in Abständen von z.B. 0,5 bis 20 mm an der Innenseite des Verschlusselements in dem Teilabschnitt desselben geformt sind, welcher aus dem Gehäusegrundkörper herausschwenkt.

Schließlich umfasst die Erfindung ebenfalls einen Schaltschrank oder ein Schaltschrankgehäuse, welcher/s eine Tür mit einem zuvor beschriebenen erfindungsgemäßen Griffelement besitzt.

Die Erfindung wird nachfolgend mit Bezug auf die Zeichnungen anhand einer bevorzugten Ausführungsform beschrieben. In den Zeichnungen zeigen
- Fig. 1: einen Schaltschrank mit einer Tür, in die ein erfindungsgemäßes Griffelement eingesetzt ist,
- Fig. 2: eine vergrößerte Darstellung des Griffelements von Fig. 1,
- Fig. 3: eine schematische räumliche Darstellung des geöffneten Griffelements mit Blick auf dessen Innenraum,
- Fig. 4: eine schematische Darstellung des erfindungsgemäßen Griffelements mit geschlossenem Verschlusselement,
- Fig. 5: eine Querschnittsansicht des geschlossenen Griffelements, und
- Fig. 6: eine schematische räumliche Ansicht des Innenraums des Gehäusegrundkörpers zur Verdeutlichung der Anordnung des laschenförmigen Rückstellelements.

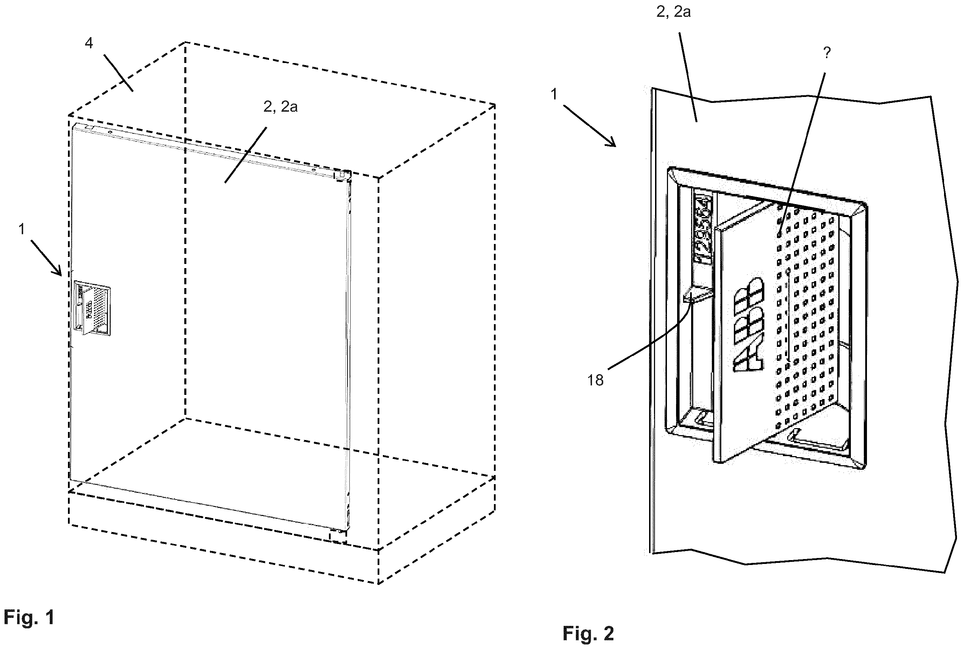

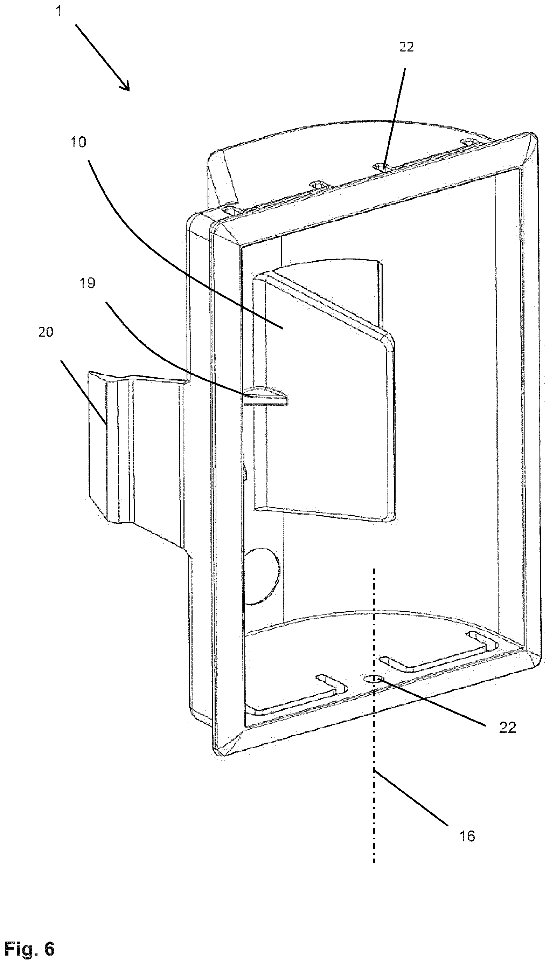

Wie in den Fig. 1 bis 6 gezeigt ist, umfasst ein erfindungsgemäßes Griffelement 1, welches zum Öffnen und Schließen einer Tür 2 eines in Fig. 1 lediglich ausschnittsweise angedeuteten Schaltschranks 4 dient, einen halbschalenförmigen Gehäusegrundkörper 6, der in eine Öffnung in der Frontseite 2a der Tür 2 einsetzbar ist und in dieser vorzugsweise über Rastelemente 20 gehalten wird.

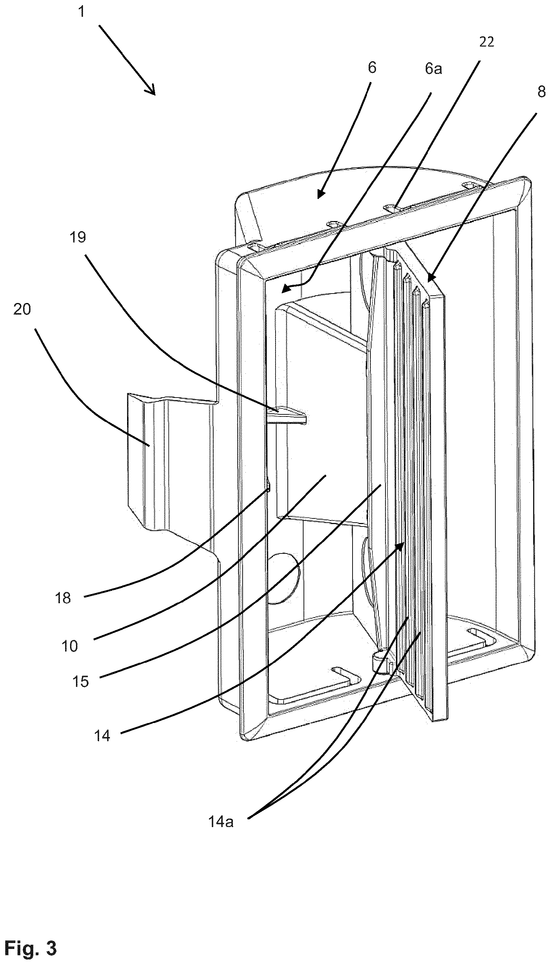

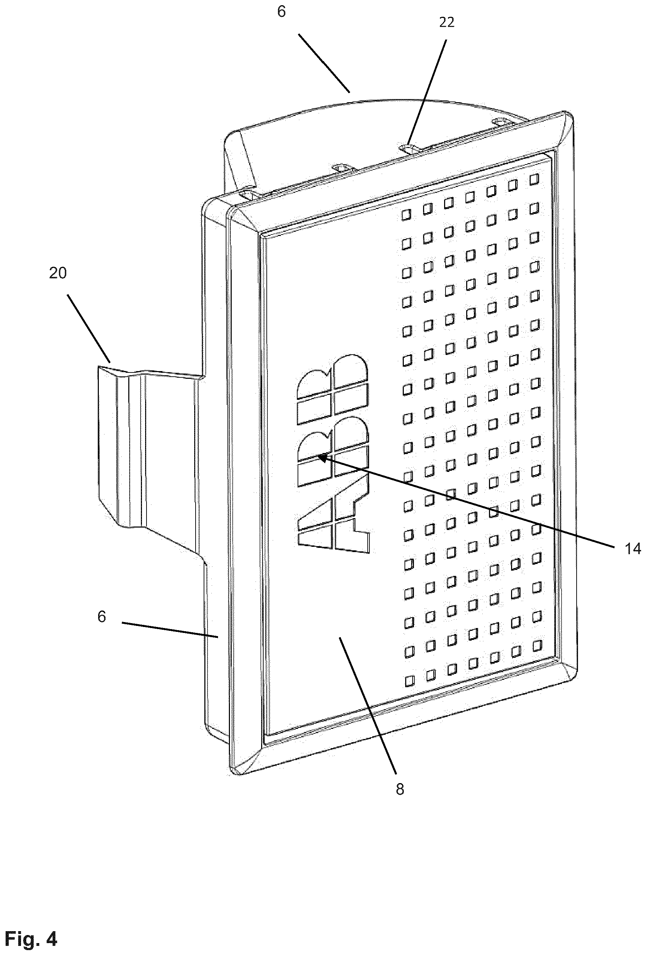

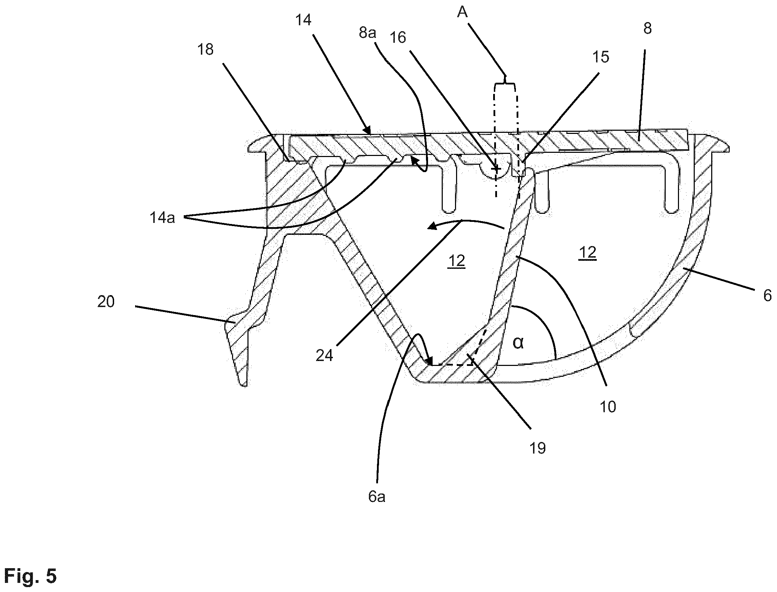

Das erfindungsgemäße Griffelement 1 umfasst weiterhin ein am Gehäusegrundkörper 6 verschwenkbar aufgenommenes plattenförmiges Verschlusselement 8, welches durch federelastische Mittel in Form eines in Fig. 3, 5 und 6 dargestellten laschenförmigen Rückstellelements 10 beaufschlagt wird und aus einer in Fig. 4 und 5 gezeigten Schließposition, in welcher das Verschlusselement 8 den Innenraum 12 des Gehäusegrundkörpers 6 verschließt und plan zur Fläche der Frontseite 2a der Tür 2 ausgerichtet ist, in eine in Fig. 1, 2 und 3 gezeigte Öffnungsposition verschwenkbar ist, in welcher das Verschlusselement 8 mit seinem einen Teilabschnitt in den Innenraum 12 einschwenkt und an dem der Schwenkachse 16 gegenüberliegenden Teilabschnitt an einer Grifffläche 14 ergriffen werden kann, um die Tür 2 zu öffnen oder zu schließen.

Der Gehäusegrundkörper 6 besteht aus einem federelastischen Werkstoff wie beispielsweise Polyamid, Polypropylen oder ABS-Kunststoff oder einem anderen geeigneten dauerhaft reversibel deformierbaren thermoplastischen Kunststoff, aus welchem erfindungsgemäß auch das laschenförmige Rückstellelement 10 geformt ist, welches zusammen mit dem übrigen Gehäusegrundkörper 6 als ein zusammenhängendes Bauteil im Spritzgussverfahren hergestellt wird.

Wie der Darstellung von Fig. 3 und 5 weiterhin im Detail entnommen werden kann, erstreckt sich das laschenförmige Rückstellelement 10 vom Boden 6a des halbschalenförmigen Gehäusegrundkörpers 6 aus durch den Innenraum 12 des Gehäusegrundkörpers 6 hindurch bis zur Innenseite 8a des Verschlusselements 8, und liegt mit seinem freien Ende an einem Anschlag 15 an, der an der Innenseite 8a des Verschlusselements 8 geformt ist und sich in entgegengesetzter Richtung in den Innenraum 12 hinein erstreckt.

Wie den Figuren 3 und 5 im Detail entnommen werden kann, ist der Anschlag 15 bevorzugt als rippenartiger Vorsprung ausgeführt, der sich insbesondere in einem rechten Winkel von der Innenseite 8a des Verschlusselements 8 weg erstreckt und der eine Länge aufweist, welche sicher stellt, dass das laschenförmige Rückstellelement 10 den Vorsprung/Anschlag 15 stets sicher hintergreift, wie dies in Fig. 3 angedeutet ist.

Gemäß der Darstellung von Fig. 5 ist das Verschlusselement 8 um die im Innenraum 12 des Gehäusegrundkörpers 6 liegende Schwenkachse 16 verschwenkbar, die in einem Abstand A vom Anschlag 15 angeordnet ist, so dass der Anschlag 15 das freie Ende des laschenförmigen Rückstellelements 10 beim Verschwenken des Verschlusselements 8 aus der Schließposition in Richtung zur Schwenkachse 16 hin in Richtung des Pfeils 24 auslenkt. Um hierbei die vom Boden 6a des Gehäusegrundkörpers 6 aufzubringenden Rückstellkräfte effektiv in das laschenförmige Rückstellelement 10 einzuleiten, stützt sich die Basis des Rückstellelements 10 vorzugsweise über ein in Fig. 3 gezeigtes Winkelelement 19 am Boden 6a ab. Dieses ist entsprechend dem Winkel α geformt, unter welchem sich das laschenförmige Rückstellelement 10 gegenüber dem Boden 6a des halbschalenförmigen Gehäusegrundkörpers 6 geneigt durch den Innenraum 12 hindurch erstreckt.

Ein besonderer Vorteil der erfindungsgemäßen Lösung ergibt sich dadurch, dass das laschenförmige Rückstellelement 10 nach dem Einsetzen desselben in den Gehäusegrundkörper 6 bereits die gewünschte Vorspannung erzeugt, welche das plattenförmige Verschlusselement 8 in der Schließposition gegen eine Anschlagfläche 18 am Gehäusegrundkörper 6 drängt (Fig. 2 und 5), so dass sich dieses immer in der Schließposition befindet, wenn das Verschlusselement 8 nicht von Hand auf der der Anschlagfläche 18 gegenüberliegenden Seite in den Innenraum 12 hinein gedrückt wird.

Um einen besonders einfachen und zeitsparenden Zusammenbau des Griffelements 1 zu ermöglichen, stützt sich das Verschlusselement 8 über in den Figuren nicht näher erkennbare zapfenförmige Vorsprünge am Gehäusegrundkörper 6 ab, welche in korrespondierende buchsenförmige Aufnahmen 22 eingreifen, bzw. in diese einrastbar sind, welche entlang der Schwenkachse 16 in den einander gegenüberliegenden Seitenwänden des Gehäusegrundkörpers 6 angeordnet sind. Das Einführen und Einrasten der zapfenartigen Vorsprünge in die buchsenförmigen Aufnahmen 22 kann dadurch erfolgen, dass der Gehäusegrundkörper 6 in einer Ebene senkrecht zur Schwenkachse 16, die z.B. durch das Zentrum des laschenförmigen Rückstellelements 10 verläuft, soweit zusammen gedrückt wird, dass sich die freien Enden der zapfenartigen Vorsprünge von den buchsenförmigen Aufnahmen 22 weg bewegen und dadurch den nötigen Abstand schaffen, um die freien Enden der zapfenartigen Vorsprünge über die Seitenwände des Gehäusegrundkörpers 6 hinweg in die buchsenförmigen Aufnahmen 22 zu bewegen, in denen diese einrasten, wenn die Druckkraft aufgehoben wird und der Gehäusegrundkörper 6 wieder seine Ursprungsform annimmt. Hierbei stellt es einen besonderen Vorteil dar, dass mit Ausnahme des Einführens der zapfenartigen Vorsprünge in die buchsenförmigen Aufnahmen 22 keine zusätzlichen Bauteile, wie z.B. Spiralfedern, benötigt und positioniert werden müssen, um die Vorspannung zwischen dem freien Ende des laschenförmigen Rückstellelements 10 und dem Anschlag 15 zu erzeugen. Dies erleichtert den Zusammenbau des erfindungsgemäßen Griffelements 1 erheblich.

Weiterhin kann, wie bereits zuvor erwähnt, an der Außenseite des halbschalenförmigen Gehäusegrundkörpers 8 wenigstens ein elastisch deformierbares Rastelement 20 geformt sein, welches im Querschnitt z.B. eine in Fig. 3, 5 und 6 angedeutete hakenartige bzw. widerhakenartige Form aufweist und bevorzugt ebenfalls integral mit dem Gehäusegrundkörper 8 geformt ist. Das Rastelement 20 hintergreift dabei den Rand der Öffnung, nachdem der Gehäusegrundkörper 6 in die entsprechende Öffnung in einer Tür 2 eingeschoben wurde, wie dies in Fig. 1 und 2 gezeigt ist.

Um schließlich die Gefahr eines Abrutschens der Finger vom Verschlusselement 8 beim Öffnen der Tür 2 so weit wie möglich zu verringern, kann die Grifffläche 14 zur Erhöhung der Reibkraft beim Ergreifen des Verschlusselements 8 mehrere Griffleisten 14a umfassen, welche vorzugsweise in Abständen von z.B. 0,5 bis 20 mm an der Innenseite 8a des Verschlusselements 8 geformt sind, wie dies in Fig. 3 und 5 angedeutet ist.

### Bezugszeichenliste

- 1: Griffelement
- 2: Tür
- 2a: Frontseite der Tür
- 4: Schrank
- 6: Gehäusegrundkörper
- 6a: Bodenplatte des Gehäusegrundkörpers
- 8: plattenförmiges Verschlusselement
- 8a: Innenseite des Verschlusselements
- 10: laschenförmiges Rückstellelement
- 12: Innenraum
- 14: Grifffläche
- 14a: Griffleisten
- 15: Anschlag
- 16: Schwenkachse
- 18: Anschlagfläche
- 19: Winkelelement
- 20: Rastelement
- 22: buchsenförmige Aufnahme
- 24: Pfeil, der Auslenkrichtung angibt
- α: Winkel zwischen Bodenfläche und Längsachse Rückstellelement
- A: Abstand zum Anschlag

## Patentansprüche

1. Griffelement (1) zur Aufnahme in der Frontseite (2a) einer Tür (2) eines Schranks (4), insbesondere eines Schaltschranks, umfassend einen halbschalenförmigen Gehäusegrundkörper (6), der in eine in der Frontseite (2a) der Tür (2) geformte Öffnung einsetzbar ist, sowie ein am Gehäusegrundkörper (6) verschwenkbar gelagertes, durch federelastische Mittel beaufschlagtes plattenförmiges Verschlusselement (8), welches aus einer Schließposition, in welcher das Verschlusselement (8) den Innenraum (12) des Gehäusegrundkörpers (6) verschließt, in eine Öffnungsposition verschwenkbar ist, in welcher das Verschlusselement (8) zum Öffnen der Tür (2) an einer Grifffläche (14) ergreifbar ist,
**dadurch gekennzeichnet, dass**
die federelastischen Mittel ein integral mit dem Gehäusegrundkörper (6) geformtes laschenförmiges Rückstellelement (10) umfassen, welches auf die dem Innenraum (12) zugewandte Innenseite (8a) des Verschlusselements (8) wirkt und dieses in die Schließposition drängt.

2. Griffelement nach Anspruch 1,
**dadurch gekennzeichnet, dass**
sich das laschenförmige Rückstellelement (10) vom Boden (6a) des halbschalenförmigen Gehäusegrundkörpers (6) aus durch den Innenraum (12) hindurch bis zur Innenseite (8a) des Verschlusselements (8) erstreckt, und dass auf der Innenseite (8a) des Verschlusselements (8) ein sich in den Innenraum (12) hinein erstreckender Anschlag (15) geformt ist, an welchem das freie Ende des laschenförmigen Rückstellelements (10) anliegt.

3. Griffelement nach Anspruch 2,
**dadurch gekennzeichnet, dass**
sich das laschenförmige Rückstellelement (10) in der Schließposition des Verschlusselementes (8) gegenüber dem Boden (6a) des halbschalenförmigen Gehäusegrundkörpers (6) in einem Winkel (α) von bevorzugt 60° bis 80° geneigt durch den Innenraum (12) hindurch erstreckt.

4. Griffelement nach einem der Ansprüche 2 oder 3,
**dadurch gekennzeichnet, dass**
der Anschlag (15) einen rippenartigen Vorsprung umfasst, der sich über die Breite des Verschlusselements (8) hinweg erstreckt.

5. Griffelement nach Anspruch 4,
**dadurch gekennzeichnet, dass**
sich der rippenartige Vorsprung (15) in einem rechten Winkel von der Innenseite (8a) des Verschlusselements (8) in den Innenraum (12) des halbschalenförmigen Gehäusegrundkörpers (6) hinein erstreckt.

6. Griffelement nach einem der vorhergehenden Ansprüche,
**dadurch gekennzeichnet, dass**
das Verschlusselement (8) um eine im Innenraum (12) des Gehäusegrundkörpers (6) liegende Schwenkachse (16) verschwenkbar ist, die in einem Abstand (A) zum Anschlag (15) angeordnet ist, derart, dass beim Verschwenken des Verschlusselements (6) aus der Schließposition der Anschlag (15) das freie Ende des laschenförmigen Rückstellelements (10) in Richtung zur Schwenkachse (16) hin auslenkt.

7. Griffelement nach einem der vorhergehenden Ansprüche,
**dadurch gekennzeichnet, dass**
sich das Verschlusselement (8) über zapfenförmige Vorsprünge verschwenkbar am Gehäusegrundkörper (6) abstützt, welche in korrespondierende buchsenförmige Aufnahmen (22) einrastbar sind.

8. Griffelement nach einem der vorhergehenden Ansprüche,
**dadurch gekennzeichnet, dass**
in einem entfernt von der Grifffläche (14) gelegenen Randbereich des Gehäusegrundkörpers (6) eine Anschlagfläche (18) geformt ist, auf welcher sich das Verschlusselement (8) in der Schließposition abstützt.

9. Griffelement nach einem der vorhergehenden Ansprüche,
**dadurch gekennzeichnet, dass**
an der Außenseite des halbschalenförmigen Gehäusegrundkörpers (6) ein elastisch deformierbares Rastelement (20) geformt ist, welches den Gehäusegrundkörper (6) nach dem Einführen in eine in einer Tür 2 geformte Öffnung in dieser fixiert.

10. Griffelement nach einem der vorhergehenden Ansprüche,
**dadurch gekennzeichnet, dass**
der Gehäusegrundkörper (6) aus einem reversibel deformierbaren Kunststoffmaterial, insbesondere Polyamid oder Polypropylen oder PVC, geformt ist.

11. Griffelement nach einem der vorhergehenden Ansprüche,
**dadurch gekennzeichnet, dass**
die Grifffläche (14) zur Erhöhung der Reibkraft beim Ergreifen des Verschlusselements (8) mehrere Griffleisten (14a) umfasst.

12. Schaltschrank (4) enthaltend eine Tür (2) mit einem Griffelement (1) nach einem der vorhergehenden Ansprüche.

## Claims

1. Handle element (1) for mounting in the front side (2a) of a door (2) of a cabinet (4), in particular of a switchgear cabinet, comprising a half-shell-shaped basic housing body (6), which is insertable into an opening formed in the front side (2a) of the door (2), and a plate-like closure element (8) that is mounted in a pivotable manner on the basic housing body (6) and is acted on by spring-elastic means, said closure element being pivotable from a closed position, in which the closure element (8) closes the interior (12) of the basic housing body (6), into an open position, in which the closure element (8) is able to be grasped at a gripping surface (14) in order to open the door (2),
**characterized in that**
the spring-elastic means comprise a tab-like restoring element (10) integrally formed with the basic housing body (6), said restoring element (10) acting on the inner side (8a), facing the interior (12), of the closure element (8) and urging the latter into the closed position.

2. Handle element according to Claim 1,
**characterized in that**
the tab-like restoring element (10) extends from the bottom (6a) of the half-shall-shaped basic housing body (6) through the interior (12) as far as the inner side (8a) of the closure element (8), and **in that** a stop (15) that extends into the interior (12) is formed on the inner side (8a) of the closure element (8), the free end of the tab-like restoring element (10) bearing against said stop (15).

3. Handle element according to Claim 2,
**characterized in that**
the tab-like restoring element (10), in the closed position of the closure element (8), extends through the interior (12) in a manner inclined at an angle (α) of preferably 60° to 80° with respect to the bottom (6a) of the half-shell-shaped basic housing body (6).

4. Handle element according to either of Claims 2 and 3,
**characterized in that**
the stop (15) comprises a rib-like protrusion that extends across the width of the closure element (8) .

5. Handle element according to Claim 4,
**characterized in that**
the rib-like protrusion (15) extends into the interior (12) of the half-shell-shaped basic housing body (6) at right angles from the inner side (8a) of the closure element (8).

6. Handle element according to one of the preceding claims,
**characterized in that**
the closure element (8) is pivotable about a pivot axis (16) lying in the interior (12) of the basic housing body (6), said pivot axis (16) being arranged at a distance (A) from the stop (15) such that, when the closure element (6) is pivoted out of the closed position, the stop (15) deflects the free end of the tab-like restoring element (10) in the direction of the pivot axis (16).

7. Handle element according to one of the preceding claims,
**characterized in that**
the closure element (8) is supported on the basic housing body (6) in a pivotable manner via peg-like protrusions, which are able to be latched in corresponding socket-like receptacles (22).

8. Handle element according to one of the preceding claims,
**characterized in that**
a stop surface (18) is formed in a peripheral region of the basic housing body (6) that is located at a distance from the gripping surface (14), the closure element (8) being supported on said stop surface (18) in the closed position.

9. Handle element according to one of the preceding claims,
**characterized in that**
an elastically deformable latch element (20) is formed on the outer side of the half-shell-shaped basic housing body (6), said latch element (20) fixing the basic housing body (6) in an opening formed in a door (2) after it has been introduced into said opening.

10. Handle element according to one of the preceding claims,
**characterized in that**
the basic housing body (6) is formed from a reversible deformable plastics material, in particular polyamide or polypropylene or PVC.

11. Handle element according to one of the preceding claims,
**characterized in that**
the gripping surface (14) comprises a plurality of gripping strips (14a) in order to increase the frictional force when the closure element (8) is grasped.

12. Switchgear cabinet (4) containing a door (2) having a handle element (1) according to one of the preceding claims.

## Revendications

1. Élément de préhension (1) destiné à être reçu dans le côté frontal (2a) d'une porte (2) d'une armoire (4), notamment d'une armoire de distribution, comprenant un corps de base de boîtier en forme de demi-coque (6), qui est insérable dans une ouverture formée dans le côté frontal (2a) de la porte (2), ainsi qu'un élément de fermeture en forme de plaque (8) monté en pivotement sur le corps de base de boîtier (6), sollicité par des moyens élastiques, qui à partir d'une position de fermeture, dans laquelle l'élément de fermeture (8) ferme l'espace intérieur (12) du corps de base de boîtier (6), peut être pivoté dans une position d'ouverture, dans laquelle l'élément de fermeture (8) peut être saisi au niveau d'une surface de préhension (14) pour l'ouverture de la porte (2),
**caractérisé en ce que**
les moyens élastiques comprennent un élément de rappel en forme de languette (10) formé d'un seul tenant avec le corps de base de boîtier (6), qui agit sur le côté intérieur (8a), tourné vers l'espace intérieur (12), de l'élément de fermeture (8) et pousse celui-ci dans la position de fermeture.

2. Élément de préhension selon la revendication 1, **caractérisé en ce que** l'élément de rappel en forme de languette (10) s'étend à partir du fond (6a) du corps de base de boîtier en forme de demi-coque (6) au travers de l'espace intérieur (12) jusqu'au côté intérieur (8a) de l'élément de fermeture (8), et **en ce qu'**une butée (15) s'étendant dans l'espace intérieur (12) est formée sur le côté intérieur (8a) de l'élément de fermeture (8), sur laquelle l'extrémité libre de l'élément de rappel en forme de languette (10) repose.

3. Élément de préhension selon la revendication 2, **caractérisé en ce que,** dans la position de fermeture de l'élément de fermeture (8), l'élément de rappel en forme de languette (10) s'étend au travers de l'espace intérieur (12) incliné par rapport au fond (6a) du corps de base de boîtier en forme de demi-coque (6) à un angle (α) de préférence de 60° à 80°.

4. Élément de préhension selon l'une quelconque des revendications 2 ou 3, **caractérisé en ce que** la butée (15) comprend une protubérance de type nervure, qui s'étend sur la largeur de l'élément de fermeture (8).

5. Élément de préhension selon la revendication 4, **caractérisé en ce que** la protubérance de type nervure (15) s'étend à un angle droit à partir du côté intérieur (8a) de l'élément de fermeture (8) dans l'espace intérieur (12) du corps de base de boîtier en forme de demi-coque (6).

6. Élément de préhension selon l'une quelconque des revendications précédentes, **caractérisé en ce que** l'élément de fermeture (8) est pivotable autour d'un axe de pivotement (16) situé dans l'espace intérieur (12) du corps de base de boîtier (6), qui est agencé à un écart (A) de la butée (15), de telle sorte que lors du pivotement de l'élément de fermeture (6) à partir de la position de fermeture, la butée (15) dévie l'extrémité libre de l'élément de rappel en forme de languette (10) dans la direction de l'axe de pivotement (16) .

7. Élément de préhension selon l'une quelconque des revendications précédentes, **caractérisé en ce que** l'élément de fermeture (8) s'appuie en pivotement sur le corps de base de boîtier (6) par l'intermédiaire de protubérances en forme de chevilles, qui peuvent être encliquetées dans des évidements en forme de douilles correspondants (22).

8. Élément de préhension selon l'une quelconque des revendications précédentes, **caractérisé en ce qu'**une surface de butée (18) est formée dans une zone de bord, éloignée de la surface de préhension (14), du corps de base de boîtier (6), sur laquelle l'élément de fermeture (8) s'appuie dans la position de fermeture.

9. Élément de préhension selon l'une quelconque des revendications précédentes, **caractérisé en ce qu'**un élément d'arrêt déformable élastiquement (20) est formé sur le côté extérieur du corps de base de boîtier en forme de demi-coque (6), qui, après l'introduction dans une ouverture formée dans une porte (2), fixe le corps de base de boîtier (6) dans celle-ci.

10. Élément de préhension selon l'une quelconque des revendications précédentes, **caractérisé en ce que** le corps de base de boîtier (6) est formé en une matière plastique déformable de manière réversible, notamment en polyamide ou polypropylène ou PVC.

11. Élément de préhension selon l'une quelconque des revendications précédentes, **caractérisé en ce que** la surface de préhension (14) comprend plusieurs baguettes de préhension (14a) pour augmenter la force de friction lors de la saisie de l'élément de fermeture (8).

12. Armoire de distribution (4) contenant une porte (2) avec un élément de préhension (1) selon l'une quelconque des revendications précédentes.
